# EUROPEAN PATENT SPECIFICATION

(11) **EP 2 474 742 B1**
(45) Date of publication and mention of the grant of the patent: **06.07.2016**
(21) Application number: 11003528.4
(22) Date of filing: 29.04.2011
(51) Int. Cl.: F04D 17/04, F04D 25/06, F04D 29/42, G06F 1/20

(54) **Cooling fan**
Kühlungsventilator
Ventilateur de refroidissement

(30) Priority: 10.01.2011 TW 100100778
(43) Date of publication of application: 11.07.2012
(73) Proprietor: Sunonwealth Electric Machine Industry Co., Ltd., Kaohsiung, Taiwan R.O.C. (TW)
(72) Inventor: Horng, Alex, Kaohsiung (TW); Wang, Ko-Chien, Kaohsiung (TW); Chen, Yeh-Feng, Kaohsiung (TW)
(74) Representative: Louis Pöhlau Lohrentz

(56) References cited:
- WO-A1-2010/058666
- DE-A1- 1 428 174
- DE-A1- 4 023 261
- JP-A- 2003 307 198
- US-A1- 2007 166 177
- US-A1- 2007 212 211

## Description

### BACKGROUND OF THE INVENTION

### 1. Field of the Invention

The present invention relates to a cooling fan and, more particularly, to a cooling fan that can conduct air currents to flow in and to flow out through a radial direction of an impeller.

### 2. Description of the Related Art

Conventional cooling fans are mainly divided into two types: axial-flow type and blower type. Each cooling fan of the axial-flow type has an axial air inlet and an axial air outlet thereof opposite to each other in the axial direction, which can conduct airflows directly flowing in and flowing out via the axial air inlet and the axial air outlet to dissipate heat. On the other hand, each cooling fan of the blower type has an axial air inlet in the axial direction, and a radial air outlet in the radial direction thereof, which can dissipate heat by inhaling air through the axial air inlet and sequentially exhaling air via the radial air outlet.

However, cooling fans of the axial-flow type can not provide radial heat-dissipation because there is no passageway of airflows in the radial direction. Therefore, cooling fans of the axial-flow type have to be disposed on the heat source, for example at the top of the central processor of a personal computer, when it is practically used in any electric equipment. In this situation, the axial height of the electric equipment needs to be maintained at a proper range for the axial-flow cooling fan to be axially mounted on the heat source, which leads to difficulty in axial miniaturization of the electric equipment. Yet, cooling fans of the blower type are not suitable for using in electric equipments that only allow for radial airflow-circuit, such as mobile phones and personal digital assistants, due to the allocations of the axial air inlet in cooling fans of the blower type.

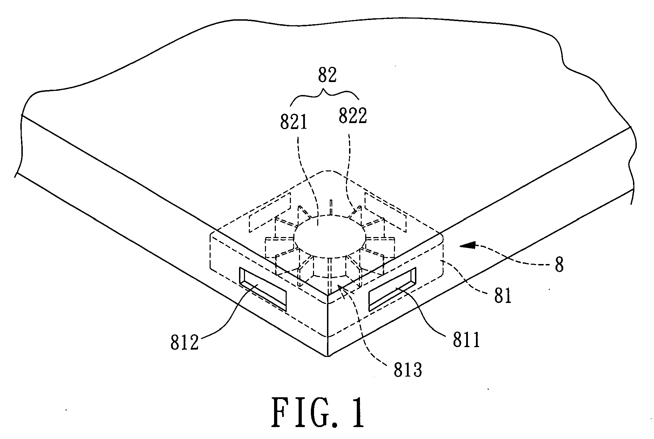

Accordingly, the other type of conventional cooling fan, capable of inhaling and exhaling air flowing in a radial direction of an impeller, is designed in order to adapt to electric equipments that only allow for radial airflow. As shown in Fig. 1, a first conventional cooling fan 8 disclosed in Taiwan Patent Issue No. 553323 and entitled "FAN STRUCTURE HAVING HORIZONTAL CONVECTION" comprises a housing 81 and an impeller 82. The housing 81 has at least one air inlet 811 and at least one air outlet 812, with a horizontal air-passageway 813 defined between the air inlet 811 and the air outlet 812. The impeller 82 is mounted inside the horizontal air-passageway 813 and comprises a hub 821 and a plurality of blades 822 mounted to the peripheral surface thereof. Accordingly, the difference in air pressure between the air inlet 811 and the air outlet 812, generated by the rotating impeller 82, can facilitate the heat-dissipation by driving air currents flowing from the air inlet 811 through the horizontal air-passageway 813 to the air outlet 812.

However, when the airflows are conducted by the plurality of blades 822 of the impeller 82 and pass through the horizontal air-passageway 813 for air convection, the hub 821 easily disturbs the airflows as well as generates air turbulence due to the location of the hub 821. Hence, the cooling efficiency of the conventional cooling fan 8 is limited.

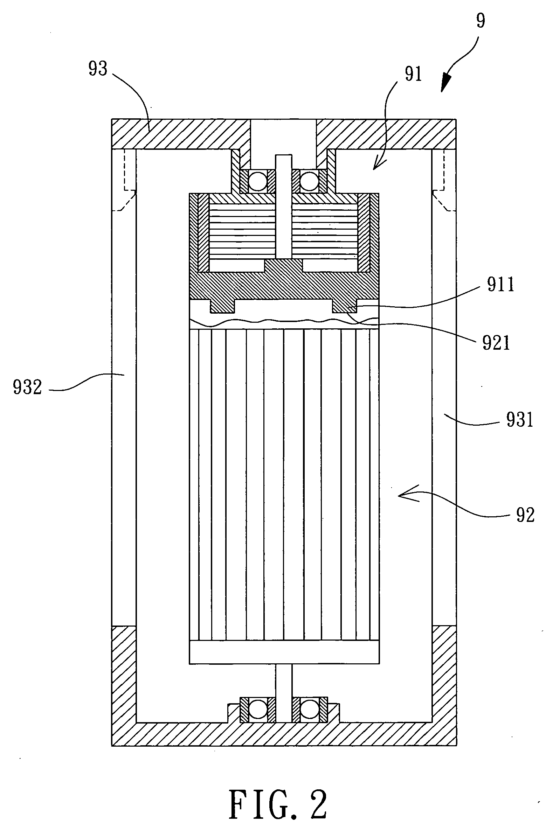

Also, another conventional cooling fan 9 is described in Taiwan Patent Issue No. 477492, entitled "CONNECTION OF BLOWER FAN" and shown in Fig.2, comprising a rotor seat 91, an impeller 92 and a housing 93. The rotor seat 91 has a plurality of blocks 911 and the impeller 92 has a plurality of holes 921, with the plurality of blocks 911 respectively coupled to the plurality of holes 921. The housing 93 is used for containing the rotor seat 91 and the impeller 92, and the housing 93 has an air inlet 931 and an air outlet 932. In this way, the rotating impeller 92 propels airflows radially flowing into the housing 93 from the air inlet 931 and sequentially flowing out from the air outlet 932 for heat-dissipation.

Nevertheless, the rotor seat 91 and the impeller 92 are both located in the air passageway between the air inlet 931 and the air outlet 932, which causes air turbulences to easily happen to the airflows conducted by the impeller 92 because of the disturbance of the rotor seat 91. Also, an additional step to assemble the impeller 92 and the rotor seat 91 need to be executed before they are inserted into the housing 93 so that the fabrication of the conventional cooling fan 9 is inconvenient and troublesome.

A cross flow fan is described in the US Patent Application US 2007/0166177 A1, entitled "THIN AIR PROCESSING DEVICE FOR HEAT VENTILATION AIR CONDITIONING SYSTEM". The cross flow fan contains a housing having a compartment formed inside, and a lateral air inlet and a lateral air outlet both penetrating through the inner and outer surfaces of the housing. Inside the housing the fan contains further a stator and an impeller as the rotor of the motor, wherein the impeller contains a hub and a plurality of blades mounted on top of the hub.

Another cross flow fan is described in the International Publication WO 2010/058666 A1, entitled "AIR CONDITIONER". The cross flow fan is designed to be rotated by an outer rotor motor having a stator part and a rotor part.

### SUMMARY OF THE INVENTION

The primary objective of this invention is to provide a cooling fan whose impeller can effectively prevent air disturbances when it conducts airflows to radially flow in and radially flow out.

A cooling fan comprising a housing and a motor is presented, wherein the words top and lateral refer to a position of the cooling fan in which its rotation axis is vertical. The housing includes a support portion, a cover portion and a lateral wall portion, with the lateral wall portion disposed between the cover portion and the support portion, with the lateral wall portion, the support portion and the cover portion defining a compartment, and with the lateral wall portion having at least one lateral air inlet and at least one lateral air outlet penetrating through the lateral wall portion and communicating with the compartment. The motor is mounted inside the compartment of the housing and contains a stator and an impeller, with the impeller rotatably mounting to the stator, and further containing a hub with a top and a plurality of blades, with the hub containing a cylindrical wall, with the top facing the cover portion, with the top and the cover portion forming a lateral flow path in the compartment, and with each blade being contained in the lateral flow path. An annular plate radially extends from an upper part of an outer periphery of the cylindrical wall of the hub adjacent to the top of the hub. The blades are mounted on the annular plate and extend towards the cover portion. The support portion forms a recess in communication with the compartment, with the stator of the motor and the hub of the impeller received in the recess. The motor is an outer rotor motor, and the hub which is received in the recess is a rotor part of the motor. The recess has a radial extent from a central axis of the recess, and the annular plate has a radial extent from the central axis of the recess larger than the radial extent of the recess. An upper surface of the annular plate faces the cover portion, the upper surface has a level difference (d) relative to the top of the hub in an axial direction of the housing, and the level difference (d) is smaller or equal to half of an axial length of the blades.

Further scope of the applicability of the present invention will become apparent from the detailed description given hereinafter. However, it should be understood that the detailed description and specific examples, while indicating preferable embodiments of the invention, are given by way of illustration only, since various others will become apparent from this detailed description to those skilled in the art.

### BRIEF DESCRIPTION OF THE DRAWINGS

The present invention will become more fully understood from the detailed description given herein below and the accompanying drawings which are given by way of illustration only, and thus are not limitative of the present invention, and wherein:
Fig. 1 is a perspective view illustrating a conventional cooling fan;
Fig. 2 is a cross sectional view illustrating another conventional cooling fan;
Fig. 3 is an exploded perspective view illustrating a cooling fan in accordance with a first illustrative example which does not belong to the invention, but which is helpful to explain inventive features;
Fig. 4 shows a cross sectional view of the cooling fan in accordance with the first example;
Fig. 5 is an exploded perspective view illustrating the cooling fan in accordance with a second illustrative example which does not belong to the invention, but which is helpful to explain inventive features;
Fig. 6 shows a cross sectional view of the cooling fan in accordance with the second example;
Fig. 7 shows a cross section view of the cooling fan in accordance with the other practice of the second example;
Fig. 8 shows a cross section view of a cooling fan, which has a support portion with through-holes.
Fig. 9 shows a cross section view of a cooling fan of the present invention, which has an impeller with an annular plate.
Fig. 10 shows a performance chart illustrating a cooling fan with different level differences.

All figures are drawn for ease of explaining the basic teachings of the present invention only; the extensions of the figures with respect to number, position, relationship, and dimensions of the parts to form the preferred embodiment will be explained or will be within the skill of the art after the following teachings of the present invention have been read and understood. Further, the exact dimensions and dimensional proportions conforming to specific force, weight, strength, and similar requirements will likewise be within the skill of the art after the following teachings of the present invention have been read and understood.

Where used in the various figures of the drawings, the same numerals designate the same or similar parts. Furthermore, when the terms "first", "second", "inner", "end", "portion", "section", "top", "bottom", "axial", "radial", "spacing", and similar terms are used herein, it should be understood that these terms refer only to the structure shown in the drawings as it would appear to a person viewing the drawings, and are utilized only to facilitate describing the invention.

### DETAILED DESCRIPTION OF THE INVENTION

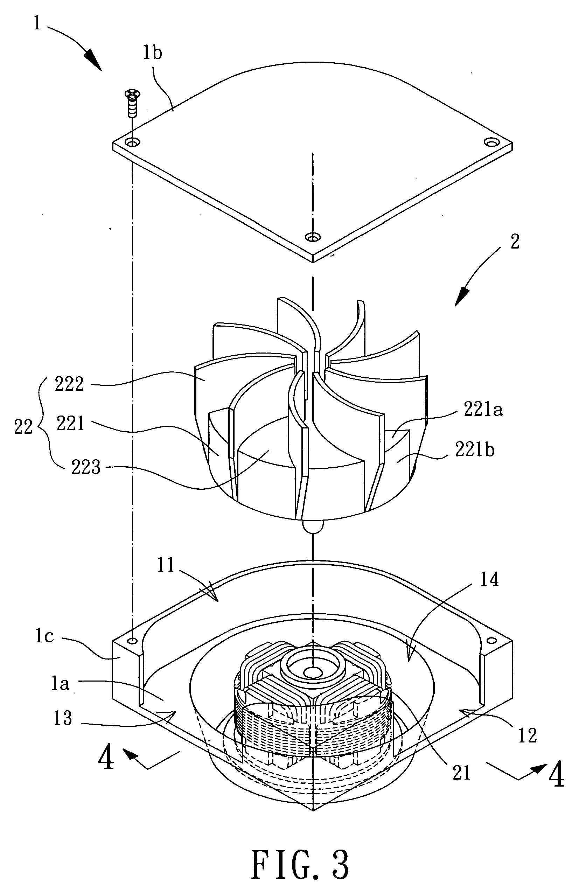

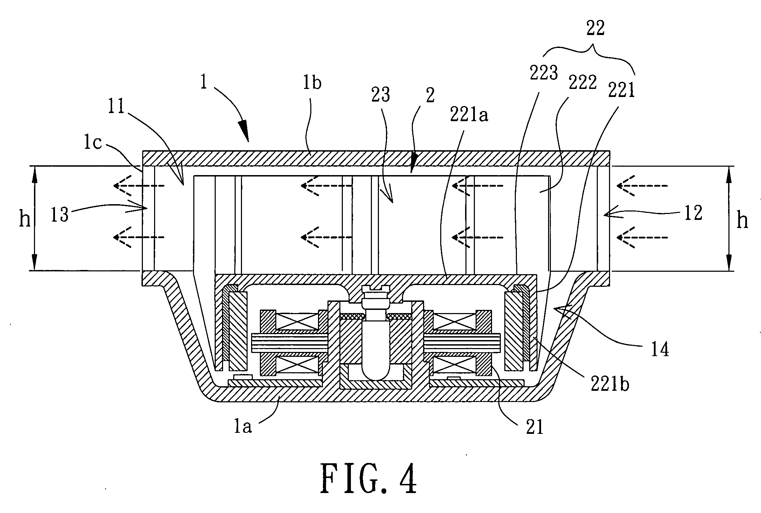

Referring to Figs. 3 and 4, in accordance with a first illustrative example which does not belong to the invention, but which is helpful to explain inventive features, the cooling fan comprises a housing 1 and a motor 2. The housing 1 provides a housing structure for driving airflows to flow in a radial direction. The motor 2 is mounted to the inner part of the housing 1.

The housing 1 is any possible hollow housing structure for not only containing the motor 2, but also radially bringing in and bringing out airflows. The housing 1 has a support portion 1a, a cover portion 1b and a lateral wall portion 1c, with the support portion 1a opposite to the cover portion 1b, with the lateral wall portion 1c linking and sandwiched in between the support portion 1a and the cover portion 1b, and with the support portion 1a, the cover portion 1b and the lateral wall portion 1c jointly defining a compartment 11. The lateral wall portion 1c has at least one lateral air inlet 12 and at least one lateral air outlet 13, with the at least one lateral air inlet 12 and the at least one lateral air outlet 13 penetrating through both the inner and outer surfaces of the lateral wall portion 1c, and communicating with the compartment 11.

In the example, the support portion 1a is a base; the lateral wall portion 1c is a plurality of lateral walls axially extending from a lateral edge of the base; and the cover portion 1b is a cover plate mounted to the top edge of the plurality of lateral walls. The compartment 11 is formed between the base and the cover plate, with the plurality of lateral walls surrounding the compartment 11. The lateral air inlet 12 and the lateral air outlet 13 are separately arranged in two of the lateral walls. In the present example as shown in Fig. 3, the lateral air inlet 12 and the lateral air outlet 13 can be formed respectively on two adjacent lateral walls. However, the lateral air inlet 12 and the lateral air outlet 13 can also be arranged in opposite two of the lateral walls. Moreover, the base further has a recess 14 at the center. The recess 14 is arranged in the compartment 11 for containing the motor 2 inside the recess 14.

The motor 2 mounted to the housing 1 comprises a stator 21 and an impeller 22 (also called a rotor), with the stator 21 controlling the rotation of the impeller 22. The impeller 22 has a hub 221 and a plurality of blades 222, with each blade 222 mounted to the hub 221. The hub 221 has a top 223, with the top 223 facing the cover portion 1b, and with a space between the top 223 and the cover portion 1b delimiting a lateral flow path 23 in the compartment 11. As shown in Fig. 4, the hub 221 is right outside the lateral flow path 23 and each blade 222 is disposed inside the lateral flow path 23, wherein each blade 222 is preferably mounted to the hub 221.

In the example, the stator 21 of the motor 2 is mounted to the recess 14 of the housing 1, wherein the hub 221 of the impeller 22 is rotatably coupled to the stator 21 and disposed in the recess 14. The hub 221 disposed in the recess 14 comprises a base plate 221a and a peripheral wall 221b, with the peripheral wall 221 b surrounding the base plate 221 a and being received in the recess 14, and with the said top 223 arranged on the base plate 221a. Furthermore, based on the design of disposing the plurality of blades 222 inside the lateral flow path 23, the plurality of blades 222 can be mounted to the top 223 of base plate 221 a with each blade 222 axially extending toward the cover portion 1b, and with part of the bottom edge of each blade 222 extending to the peripheral surface of the peripheral wall 221b as shown in Fig. 4. Otherwise, the plurality of blades 222 also can be mounted to the top 223 only. In addition, the plurality of blades 222 may be integrally formed on the top 223 of the base plate 221a so that the fabrication of the cooling fan can be conveniently achieved.

In practical use, the stator 21 of the motor 2 generates a time-varying magnetic field to propel the rotation of the impeller 22. In this situation, the cooling fan is capable of being applied to any possible electric equipment, with the plurality of blades 222 of the impeller 22 driving air currents flowing into the lateral flow path 23 via the lateral air inlet 12 and sequentially flowing out via the lateral air outlet 13, for the sake of effectively dissipating heat when the electric equipment is operating.

The cooling fan is characterized by conducting airflows to flow in and flow out the cooling fan in a radial direction of the impeller 22 through the lateral air inlet 12 and the lateral air outlet 13. Accordingly, the cooling fan is capable of being applied to any possible electric equipment, and it is unnecessary to be disposed on the heat source. In this situation, the axial height of the electric equipment can be appropriately reduced, and also the cooling effect of the cooling fan can be effectively promoted, especially for sites near the lateral air outlet 13. More significantly, when air currents are propelled by the impeller 22, inhaled or exhaled to the lateral flow path 23 from the lateral air inlet 12 and the lateral air outlet 13, the air currents will not be disturbed by the hub 221 because the hub 221 is arranged outside the lateral flow path 23 and the plurality of blades 222 is arranged inside the lateral flow path 23. Accordingly, the cooling fan of the example is efficient in preventing air turbulence and advancing the cooling effect.

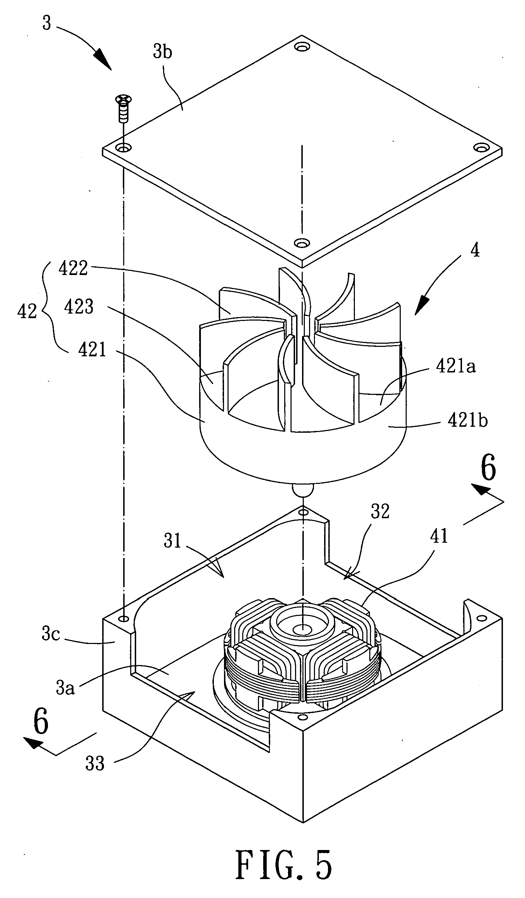

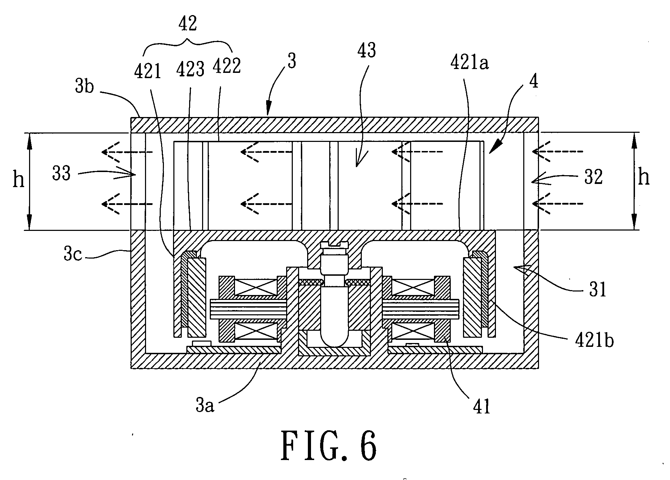

Referring to Figs. 5 and 6, in accordance with a second illustrative example which does not belong to the invention, but which is helpful to explain inventive features, the cooling fan also comprises a housing 3 and a motor 4. Similarly to the first example of cooling fan, the housing 3 also has a support portion 3a, a cover portion 3b, a lateral wall portion 3c, compartment 31, lateral air inlet 32, and lateral air outlet 33, while the motor 4 also has a stator 41, an impeller 42, a hub 421, a base plate 421a, a peripheral wall 421b, a plurality of blades 422 and a top 423, whose structures are approximately the same as that in the first example and will not be given further unnecessary details in the following section.

Similarly, the support portion 3a is a base; the lateral wall portion 3c is a plurality of lateral walls axially extending from the peripheral edge of the base; and the cover portion 3b is a cover plate. It is noted that the major difference between the second and the first examples is that: unlike the cooling fan of the first example, the support portion 3a does not have any design of recess 14 of the first example, and the stator 41 of the motor 4 is directly mounted to the center of the base, that is, the support portion 3a. Accordingly, the top 423 and the cover portion 3b delimit the lateral flow path 43 in the compartment 31, and the lateral air inlet 32 and the lateral air outlet 33 are arranged on opposite two of the lateral walls, that are the lateral wall portion 3c, as shown in Fig. 5. In the preferable example, the openings (h) of the lateral air inlet 32 and the lateral air outlet 33 extend between the cover portion 3b and the top 423 in the axial direction of the impeller 42, so that the lateral air inlet 32 and the lateral air outlet 33 can be in alignment with the plurality of blades respectively, and the hub 421 is positioned within the inside of the lateral wall portion 3c. As a result, air currents conducted by the impeller 42 and flowed in from the lateral air inlet 32 will not be disturbed by the hub 421.

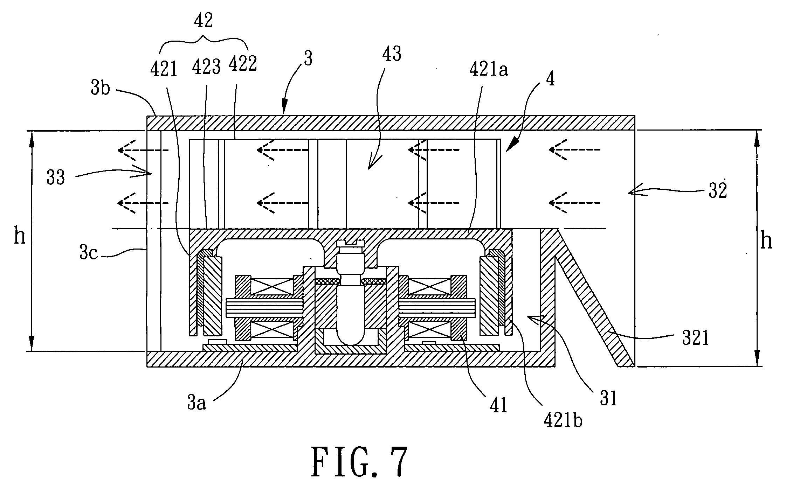

Additionally, the above description of the opening (h) of the lateral air inlet 32 and the lateral air outlet 33 is only related to the preferable example. With reference to Fig. 7, the opening (h) of the lateral air outlet 33 can further extend from the support portion 3 a to the cover portion 3b in the axial direction of the impeller 42, in order to effectively bring out airflows. Also, the opening (h) of the lateral air inlet 32 also can extend from the support portion 3a to the cover portion 3b in the axial direction of the impeller 42, and forms an air-guiding portion 321 with wide-caliber in shape, so as to increase airflows that flow in. In this situation, the impeller 42 can conduct air currents more smoothly to flow into the lateral flow path 43.

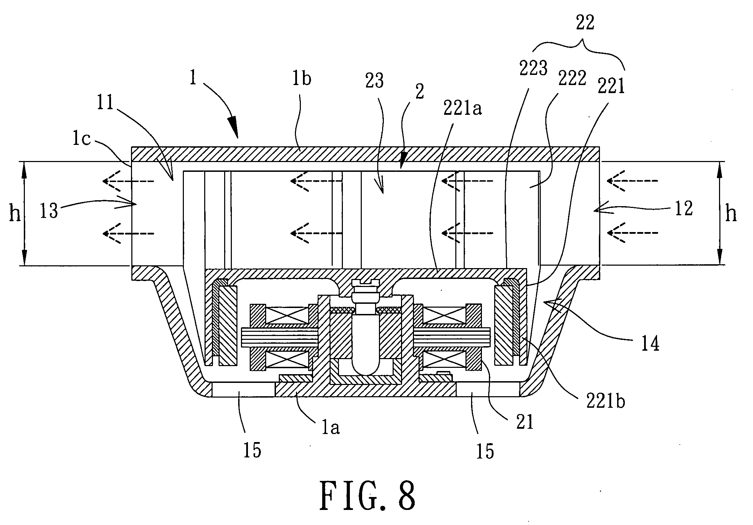

Furthermore, Fig. 8 is a modification of the support portion 1a in the cooling fan of the first example and it is also adaptable to the cooling fan of the second example. The support portion 1a, of the housing 1 further has at least one through-hole 15 to allow the circulation of air currents. In this way, when the motor 2 is mounted to the compartment 11 of the housing 1, the through-hole 15 of the support portion 1a bring in air currents for circulation, which advances the air-circulation in the cooling fan, as well as the heat-dissipation of the motor 2.

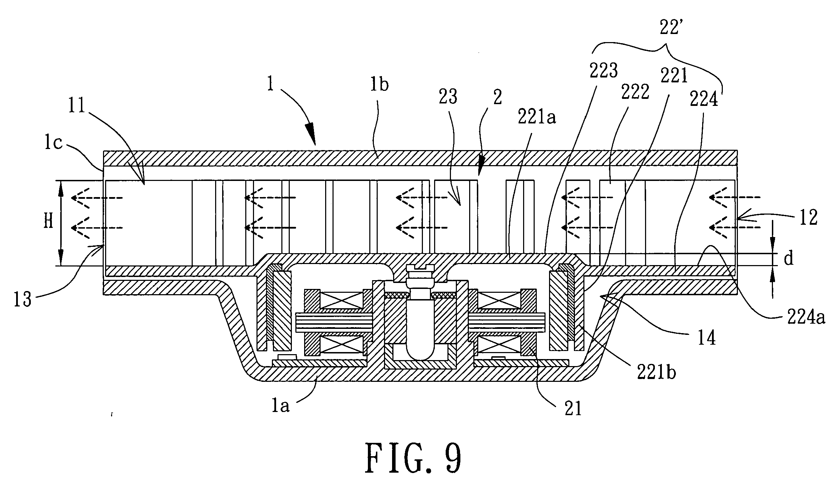

Fig. 9 shows a cross section view of a cooling fan of the present invention, which has an impeller with an annular plate.

Moreover, referring to Fig. 9, a modification of the impeller of the motor 2, and can also be adapted to the cooling fan of the second example. This modified impeller 22' also has the hub 221, blades 222, and top 223, and further provides an annular plate 224 radially extending from an outer periphery of the hub 221, with the blades 222 being mounted on an upper surface 224a of the annular plate 224 and axially extending towards the cover portion 1b. Besides, in an axial direction of the impeller 22', the upper surface 224a of the annular plate 224, which faces the cover portion 1b, has a level difference "d" relative to the top 223. When the upper surface 224a has the level difference "d" relatives to the top 223, an increased area of the blades 222 due to the level difference "d" can increase airflows flowing into and out of the housing 1. Furthermore, the level difference "d" preferably matches the following equation so as to efficiently lower the blocking affect caused by this level difference "d," level difference"d" ≤ 0.5H.
In the above equation, the "H" represents an axial length of the blades 222 in the axial direction of the impeller 22'.

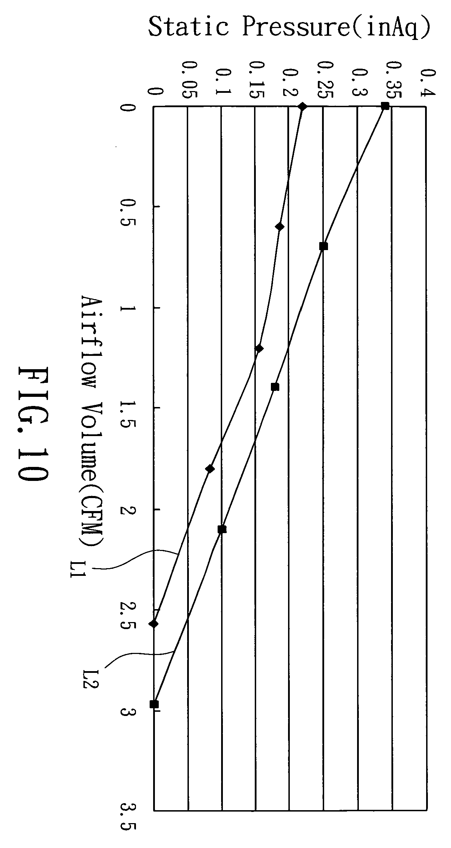

Referring to Fig. 10, a performance chart of the impeller 22' is shown. In this performance chart, line L1 illustrates an "static pressure" to "airflow volume" curve with the level difference "d" larger than 0.5H while line L2 illustrates another "static pressure" to "airflow volume" curve with the level difference "d" smaller or equal to 0.5H. In accordance with this performance chart, an impeller 22' with the level difference "d" smaller or equal to 0.5H can apparently-raise the-static pressure and airflow volume at the same time.

In summary, with the design of the lateral flow path 23, 43 of the cooling fan in the present invention, the cooling fan is sufficient in preventing air turbulence when air currents are propelled by the impeller 22, 22', 42 and circulating into the lateral flow path 23, 43 from the lateral air inlet 12, 32 to the lateral air outlet 13, 33. Therefore, the cooling effect of the present invention can be dramatically promoted.

Thus, since the invention disclosed herein may be embodied in other specific forms without departing from the general characteristics thereof, some of which forms have been indicated, the embodiments described herein are to be considered in all respects illustrative and not restrictive. The scope of the invention is indicated by the appended claims.

## Claims

1. A cooling fan comprising the following features, wherein the words top and lateral refer to a position of the cooling fan in which its rotation axis is vertical:
a housing (1) including a support portion (1 a), a cover portion (1 b) and a lateral wall portion (1c), with the lateral wall portion (1c) disposed between the cover portion (1b) and the support portion (1a), with the lateral wall portion (1c), the support portion (1a) and the cover portion (1 b) defining a compartment (11), and with the lateral wall portion (1 c) having at least one lateral air inlet (12) and at least one lateral air outlet (13) penetrating through the lateral wall portion (1c) and communicating with the compartment (11); and
a motor (2) mounted inside the compartment (11) of the housing (1) and containing a stator (21) and an impeller (22'), with the impeller (22') rotatably mounting to the stator (21),
wherein the impeller further contains a hub (221) with a top (223) and a plurality of blades (222), with the hub (221) containing a cylindrical wall, with the top (223) facing the cover portion (1b), with the top (223) and the cover portion (1b) forming a lateral flow path (23) in the compartment (11), and with each blade (222) contained in the lateral flow path (23),
wherein an annular plate (224) radially extends from an upper part of an outer periphery of the cylindrical wall of the hub (221) adjacent to the top (223) of the hub (221), and wherein the blades (222) are mounted on the annular plate (224) and extend towards the cover portion (1b),
wherein the support portion (1a) forms a recess (14) in communication with the compartment (11), with the stator (21) of the motor (2) and the hub (221) of the impeller (22') received in the recess (14),
wherein the motor (2) is an outer rotor motor, and the hub (221) which is received in the recess (14) is a rotor part of the motor (2), and
wherein the recess (14) has a radial extent from a central axis of the recess (14),
wherein the annular plate (224) has a radial extent from the central axis of the recess (14) larger than the radial extent of the recess (14),
wherein the cooling fan is **characterized in that**
an upper surface (224a) of the annular plate (224) faces the cover portion (1 b), the upper surface (224a) has a level difference (d) relative to the top (223) of the hub (221) in an axial direction of the housing (1), and the level difference (d) is smaller or equal to half of an axial length of the blades (222) and larger than zero.

2. The cooling fan as defined in claim 1, **characterized in that** the opening of the lateral air inlet (12) extends between the cover portion (1 b) and the top (223) of the hub (221) in an axial direction of the impeller (22').

3. The cooling fan as defined in claim 1, **characterized in that** the opening of the lateral air outlet (13) extends between the cover portion (1 b) and the top (223) of the hub (221) in an axial direction of the impeller (22').

4. The cooling fan as defined in claim 2, **characterized in that** the lateral air inlet (12) is aligned with the position of the plurality of blades (222) of the impeller (22') in a radial direction of the housing (1).

5. The cooling fan as defined in claim 3, **characterized in that** the lateral air outlet (13) is aligned with the position of the plurality of blades (222) of the impeller (22') in a radial direction of the housing (1).

6. The cooling fan as defined in claim 1, **characterized in that** the lateral air inlet (12) forms an air-guiding portion (321).

7. The cooling fan as defined in claim 1, **characterized in that** the support portion (1a) is a base in the form of a plate, the lateral wall portion (1c) is a plurality of lateral walls axially extending from a lateral edge of the base, the cover portion (1b) is a cover plate, with the cover plate mounted to the plurality of lateral walls, with the cover plate and the base defining the compartment (11), and with the lateral air inlet (12) and the lateral air outlet (13) respectively arranged on two adjacent lateral walls.

8. The cooling fan as defined in claim 1, **characterized in that** the support portion (1a) is a base in the form of a plate, the lateral wall portion (1c) is a plurality of lateral walls axially extending from a lateral edge of the base, the cover portion (1 b) is a cover plate, with the cover plate mounted to the plurality of lateral walls, with the cover plate and the base defining the compartment (11), and with the lateral air inlet (12) and the lateral air outlet (13) respectively arranged on two opposite lateral walls.

9. The cooling fan as defined in claim 1, **characterized in that** the plurality of blades (222) is integrally formed on the hub (221).

10. The cooling fan as defined in claim 1, **characterized in that** the support portion (1a) of the housing (1) has at least one through-hole (15).

## Patentansprüche

1. Kühlgebläse, das die folgenden Merkmale umfasst, wobei sich die Wörter oben und seitlich auf eine Position des Kühlgebläses beziehen, in der dessen Drehachse vertikal ist:
ein Gehäuse (1), das einen Tragabschnitt (1a), einen Abdeckabschnitt (1b) und einen Seitenwandabschnitt (1c) enthält, wobei der Seitenwandabschnitt (1c) zwischen dem Abdeckabschnitt (1b) und dem Tragabschnitt (1a) angeordnet ist, wobei der Seitenwandabschnitt (1c), der Tragabschnitt (1a) und der Abdeckabschnitt (1b) eine Kammer (11) definieren und wobei der Seitenwandabschnitt (1c) mindestens einen seitlichen Lufteinlass (12) und mindestens einen seitlichen Luftauslass (13) aufweist, die den Seitenwandabschnitt (1c) durchdringen und mit der Kammer (11) kommunizieren; und
einen Motor (2), der innerhalb der Kammer (11) des Gehäuses (1) montiert ist und einen Stator (21) und ein Laufrad (22') enthält, wobei das Laufrad (22') an dem Stator (21) drehbar montiert ist,
wobei das Laufrad ferner einen Radkörper (221) mit einem Deckel (223) und mehreren Schaufeln (222) enthält, wobei der Laufradkörper (221) eine zylindrische Wand enthält, wobei der Deckel (223) dem Abdeckabschnitt (1b) gegenüberliegt, wobei der Deckel (223) und der Abdeckabschnitt (1b) einen seitlichen Strömungsweg (23) in der Kammer (11) bilden und wobei jede Schaufel (222) in dem seitlichen Strömungsweg (23) enthalten ist,
wobei sich eine ringförmige Platte (224) radial von einem oberen Teil eines äußeren Umfangs der zylindrischen Wand des Radkörpers (221) benachbart zum Deckel (223) des Radkörpers (221) erstreckt und wobei die Schaufeln (222) an die ringförmigen Platte (224) montiert sind und sich in Richtung zu dem Abdeckabschnitt (1b) erstrecken,
wobei der Tragabschnitt (1a) eine Vertiefung (14) bildet, die sich in Kommunikation mit der Kammer (11) befindet, wobei der Stator (21) des Motors (2) und der Radkörper (221) des Laufrads (22') in der Vertiefung (14) aufgenommen sind,
wobei der Motor (2) ein Außenläufermotor ist und der Radkörper (221), der in der Vertiefung (14) aufgenommen ist, ein Läuferteil des Motors (2) ist, und
wobei die Vertiefung (14) eine radiale Ausdehnung von einer Mittelachse der Vertiefung (14) aufweist,
wobei die ringförmige Platte (224) eine radiale Ausdehnung von der Mittelachse der Vertiefung (14) aufweist, die größer als die radiale Ausdehnung der Vertiefung (14) ist,
wobei das Kühlgebläse **dadurch gekennzeichnet ist, dass**
eine obere Fläche (224a) der ringförmigen Platte (224) dem Abdeckabschnitt (1b) gegenüberliegt, die obere Fläche (224a) in einer axialen Richtung des Gehäuses (1) eine Höhendifferenz (d) relativ zu dem Deckel (223) des Radkörpers (221) aufweist, wobei die Höhendifferenz (d) kleiner oder gleich der Hälfte einer axialen Länge der Schaufeln (222) und größer als Null ist.

2. Kühlgebläse nach Anspruch 1, **dadurch gekennzeichnet, dass** sich die Öffnung des seitlichen Lufteinlasses (12) in einer axialen Richtung des Laufrads (222') zwischen dem Abdeckabschnitt (1b) und dem Deckel (223) des Radkörpers (221) erstreckt.

3. Kühlgebläse nach Anspruch 1, **dadurch gekennzeichnet, dass** sich die Öffnung des seitlichen Luftauslasses (13) in einer axialen Richtung des Laufrads (222') zwischen dem Abdeckabschnitt (1b) und dem Deckel (223) des Radkörpers (221) erstreckt.

4. Kühlgebläse nach Anspruch 2, **dadurch gekennzeichnet, dass** der seitliche Lufteinlass (12) in einer radialen Richtung des Gehäuses (1) auf die Position der mehreren Schaufeln (222) des Laufrads (22') ausgerichtet ist.

5. Kühlgebläse nach Anspruch 3, **dadurch gekennzeichnet, dass** der seitliche Luftauslass (13) in einer radialen Richtung des Gehäuses (1) auf die Position der mehreren Schaufeln (222) des Laufrads (22') ausgerichtet ist.

6. Kühlgebläse nach Anspruch 1, **dadurch gekennzeichnet, dass** der seitliche Lufteinlass (12) einen Luftleitabschnitt (321) bildet.

7. Kühlgebläse nach Anspruch 1, **dadurch gekennzeichnet, dass** der Tragabschnitt (1a) einem Boden in Form einer Platte entspricht, der Seitenwandabschnitt (1c) mehreren Seitenwänden entspricht, die sich axial von einer seitlichen Kante des Bodens erstrecken, der Abdeckabschnitt (1b) einer Abdeckplatte entspricht, wobei die Abdeckplatte auf den mehreren Seitenwänden montiert ist, wobei die Abdeckplatte und der Boden die Kammer (11) bilden, und wobei der seitliche Lufteinlass (12) und der seitliche Luftauslass (13) jeweils an zwei benachbarten Seitenwänden angeordnet sind,

8. Kühlgebläse nach Anspruch 1, **dadurch gekennzeichnet, dass** der Tragabschnitt (1a) einem Boden in Form einer Platte entspricht, der Seitenwandabschnitt (1c) mehreren Seitenwänden entspricht, die sich axial von einer seitlichen Kante des Bodens erstrecken, der Abdeckabschnitt (1b) einer Abdeckplatte entspricht, wobei die Abdeckplatte auf den mehreren Seitenwänden montiert ist, wobei die Abdeckplatte und der Boden die Kammer (11) bilden, und wobei der seitliche Lufteinlass (12) und der seitliche Luftauslass (13) jeweils an zwei gegenüberliegenden Seitenwänden angeordnet sind.

9. Kühlgebläse nach Anspruch 1, **dadurch gekennzeichnet, dass** die mehreren Schaufeln (222) mit dem Radkörper (221) aus einem Stück gebildet sind.

10. Kühlgebläse nach Anspruch 1, **dadurch gekennzeichnet, dass** der Tragabschnitt (1a) des Gehäuses (1) mindestens ein Durchgangsloch (15) aufweist.

## Revendications

1. Ventilateur de refroidissement comprenant les caractéristiques suivantes, dans lequel les termes supérieur et latéral font référence à une position du ventilateur de refroidissement dans laquelle son axe de rotation est vertical :
un boîtier (1) comprenant une partie de support (1a), une partie de couvercle (1b) et une partie de paroi latérale (1c), avec la partie de paroi latérale (1c) disposée entre la partie de couvercle (1b) et la partie de support (1a), avec la partie de paroi latérale (1c), la partie de support (1a) et la partie de couvercle (1b) qui définissent un compartiment (11), et avec la partie de paroi latérale (1c) qui a au moins une entrée d'air latérale (12) et au moins une sortie d'air latérale (13) pénétrant à travers la partie de paroi latérale (1c) et communiquant avec le compartiment (11) ; et
un moteur (2) monté à l'intérieur du compartiment (11) du boîtier (1) et comprenant un stator (21) et une roue (22'), avec la roue (22') montée en rotation sur le stator (21),
dans lequel la roue contient en outre un moyeu (221) avec une partie supérieure (223) et une pluralité de pales (222), avec le moyeu (221) qui contient une paroi cylindrique, avec la partie supérieure (223) qui fait face à la partie de couvercle (1b), avec la partie supérieure (223) et la partie de couvercle (1b) qui forment une trajectoire d'écoulement latérale (23) dans le compartiment (11) et avec chaque pale (222) contenue dans la trajectoire d'écoulement latérale (23),
dans lequel une plaque annulaire (224) s'étend radialement à partir d'une partie supérieure d'une périphérie externe de la paroi cylindrique du moyeu (221) adjacente à la partie supérieure (223) du moyeu (221) et dans lequel les pales (222) sont montées sur la plaque annulaire (224) et s'étendent vers la partie de couvercle (1b),
dans lequel la partie de support (1a) forme un évidement (14) en communication avec le compartiment (11), avec le stator (21) du moteur (2) et le moyeu (221) de la roue (22') reçus dans l'évidement (14),
dans lequel le moteur (2) est un moteur de rotor externe, et le moyeu (221) qui est reçu dans l'évidement (14) est une partie du rotor du moteur (2), et
dans lequel l'évidement (14) a une étendue radiale à partir d'un axe central de l'évidement (14),
dans lequel, la plaque annulaire (224) a une étendue radiale à partir de l'axe central de l'évidement (14) supérieure à l'étendue radiale de l'évidement (14),
dans lequel le ventilateur de refroidissement est **caractérisé en ce que** :
une surface supérieure (224a) de la plaque annulaire (224) fait face à la partie de couvercle (1b), la surface supérieure (224a) a une différence de niveau (d) par rapport à la partie supérieure (223) du moyeu (221) dans une direction axiale du boîtier (1), et la différence de niveau (d) est inférieure ou égale à la moitié d'une longueur axiale des pales (222) et supérieure à zéro.

2. Ventilateur de refroidissement selon la revendication 1, **caractérisé en ce que** l'ouverture de l'entrée d'air latérale (12) s'étend entre la partie couvercle (1b) et la partie supérieure (223) du moyeu (221) dans une direction axiale de la roue (22').

3. Ventilateur de refroidissement selon la revendication 1, **caractérisé en ce que** l'ouverture de la sortie d'air latérale (13) s'étend entre la partie de couvercle (1b) et la partie supérieure (223) du moyeu (221) dans une direction axiale de la roue (22').

4. Ventilateur de refroidissement selon la revendication 2, **caractérisé en ce que** l'entrée d'air latérale (12) est alignée avec la position de la pluralité de pales (222) de la roue (22') dans une direction radiale du boîtier (1).

5. Ventilateur de refroidissement selon la revendication 3, **caractérisé en ce que** la sortie d'air latérale (13) est alignée avec la position de la pluralité de pales (222) de la roue (22') dans une direction radiale du boîtier (1).

6. Ventilateur de refroidissement selon la revendication 1, **caractérisé en ce que** l'entrée d'air latérale (12) forme une partie de guidage d'air (321).

7. Ventilateur de refroidissement selon la revendication 1, **caractérisé en ce que** la partie de support (1a) est une base se présentant sous la forme d'une plaque, la partie de paroi latérale (1c) est une pluralité de parois latérales s'étendant axialement à partir d'un bord latéral de la base, la partie de couvercle (1b) est une plaque de couvercle, avec la plaque de couvercle montée sur la pluralité de parois latérales, avec la plaque de couvercle et la base qui définissent le compartiment (11) et avec l'entrée d'air latérale (12) et la sortie d'air latérale (13) agencées respectivement sur deux parois latérales adjacentes.

8. Ventilateur de refroidissement selon la revendication 1, **caractérisé en ce que** la partie de support (1a) est une base se présentant sous la forme d'une plaque, la partie de paroi latérale (1c) est une pluralité de parois latérales s'étendant axialement à partir d'un bord latéral de la base, la partie de couvercle (1b) est une plaque de couvercle, avec la plaque de couvercle montée sur la pluralité de parois latérales, avec la plaque de couvercle et la base qui définissent le compartiment (11), et avec l'entrée d'air latérale (12) et la sortie d'air latérale (13) respectivement agencées sur deux parois latérales opposées.

9. Ventilateur de refroidissement selon la revendication 1, **caractérisé en ce que** la pluralité de pales (222) est formée de manière solidaire sur le moyeu (221).

10. Ventilateur de refroidissement selon la revendication 1, **caractérisé en ce que** la partie de support (1a) du boîtier (1) a au moins un trou débouchant (15).
